# EUROPEAN PATENT APPLICATION

(11) **EP 2 267 689 A1**
(43) Date of publication of application: **29.12.2010**
(21) Application number: 10157607.2
(22) Date of filing: 24.03.2010
(51) Int. Cl.: G09G 3/288

(54) **Plasma display apparatus for preventing electromagnetic interference**

(30) Priority: 22.06.2009 KR 20090055508
(71) Applicant: SAMSUNG ELECTRONICS CO., LTD., Suwon-si Gyeonggi-do 442-742 (KR)
(72) Inventor: Song, Hyun-chul, Gyeonggi-do (KR)
(74) Representative: Robinson, Ian Michael

(57) **Abstract**

A plasma display apparatus for preventing electromagnetic interference is provided. The plasma display apparatus includes: a first substrate and a second substrate which face each other with a predetermined gap therebetween, a plurality of X electrodes and a plurality of Y electrodes which are alternately arranged on the first substrate along a first direction, a plurality of address electrodes which are arranged on the second substrate along a second direction which intersects with the first direction, and an address driver which drives the plurality of address electrodes. At least one address electrode is connected to the address driver through one end of the second direction of the second substrate, and an address electrode neighboring the at least one address electrode is connected to the address driver through other end of the second direction of the second substrate.

## Description

### CROSS-REFERENCE TO RELATED APPLICATIONS

This application claims priority from Korean Patent Application No. 10-2009-0055508, filed on June 22, 2009, in the Korean Intellectual Property Office, the disclosure of which is incorporated herein by reference in its entirety.

### BACKGROUND OF THE INVENTION

### 1. Field of the Invention

Apparatuses and methods consistent with the present invention relate to a plasma display apparatus, and more particularly, to a plasma display apparatus for preventing electromagnetic interference.

### 2. Description of the Related Art

A plasma display apparatus displays an image using plasma generated from a gas discharge. Plasma display apparatuses are the next generation of display apparatuses because they are slim, light-weight, and can accommodate a large screen size. As a result, there are many studies on these plasma display apparatus.

However, with the current plasma display apparatus, electromagnetic wave noise occurs when the plasma display apparatus is driven, causing electromagnetic interference. To solve this problem, the related-art discloses a plasma display apparatus that is equipped with an electromagnetic wave shielding filter on a front surface of a plasma display panel to prevent the electromagnetic interference. However, the electromagnetic wave shielding filter deteriorates brightness of an image. Also, an electromagnetic wave shielding filter increases a manufacturing cost of plasma display apparatuses.

Accordingly, there is a demand for a plasma display apparatus that can prevent electromagnetic interference without the addition of an electromagnetic wave shielding filter.

### SUMMARY OF THE INVENTION

According to the present invention there is provided an apparatus as set forth in the appended claims. Other features of the invention will be apparent from the dependent claims, and the description which follows.

Exemplary embodiments of the present invention overcome the above disadvantages and other disadvantages not described above. Also, the present invention is not required to overcome the disadvantages described above, and an exemplary embodiment of the present invention may not overcome any of the problems described above.

Exemplary embodiments of the present invention provide a plasma display apparatus for preventing electromagnetic interference.

According to an aspect of the present invention, there is provided a plasma display apparatus including a first substrate and a second substrate which face each other with a predetermined gap therebetween, a plurality of X electrodes and a plurality of Y electrodes which are alternately arranged on the first substrate along a first direction, a plurality of address electrodes which are arranged on the second substrate along a second direction which intersects with the first direction, and an address driver which drives the plurality of address electrodes.

At least one address electrode may be connected to the address driver through one end of the second direction of the second substrate, and an address electrode neighboring the at least one address electrode may be connected to the address driver through other end of the second direction of the second substrate.

The plurality of address electrodes may be alternately connected to the address driver through one end and the other end of the second direction of the second substrate.

A predetermined number of continuous address electrodes may form an address electrode group, and a plurality of address electrode groups may be alternately connected to the address driver through one end and the other end of the second direction of the second substrate.

The address driver may include a first address driver which drives an address electrode connected thereto through one end of the second direction of the second substrate, and a second address driver which drives an address electrode connected thereto through the other end of the second direction of the second substrate.

The plasma display apparatus may further include an X driver which drives the plurality of X electrodes, and a Y driver which drives the plurality of Y electrodes.

The plasma display apparatus may further include a controller which generates a control signal by processing input video data, and transmits the control signal to the address driver, the X driver, and the Y driver.

### BRIEF DESCRIPTION OF THE DRAWINGS

The above and/or other aspects of the present invention will become more apparent by describing certain exemplary embodiments of the present invention with reference to the accompanying drawings, in which:

FIG. 1 is a schematic view illustrating a plasma display apparatus according to an exemplary embodiment of the present invention;

FIG. 2 is an exploded perspective view of the plasma display panel of FIG. 1 according to an exemplary embodiment of the present invention;

FIG. 3 is a graph comparing the result of simulating vertical radiation noise of the plasma display apparatus, according to an exemplary embodiment of the present invention as illustrated in FIG. 1, with the result of a related-art plasma display apparatus;

FIG. 4 is a schematic view illustrating a plasma display apparatus according to another exemplary embodiment of the present invention;

FIG. 5 is a schematic view illustrating a plasma display apparatus according to still another exemplary embodiment of the present invention; and

FIG. 6 is a schematic view illustrating a plasma display apparatus according to still another exemplary embodiment of the present invention.

### DETAILED DESCRIPTION OF EXEMPLARY EMBODIMENTS

Exemplary embodiments of the present invention are described in greater detail below with reference to the accompanying drawings.

In the following description, the same drawing reference numerals are used for the like or same elements even in different drawings. The matters defined in the description, such as detailed construction and elements, are provided to assist in a comprehensive understanding of the invention. However, the present invention can be practiced without those specifically defined matters. Also, well-known functions or constructions are not described in detail since they would obscure the invention with unnecessary detail.

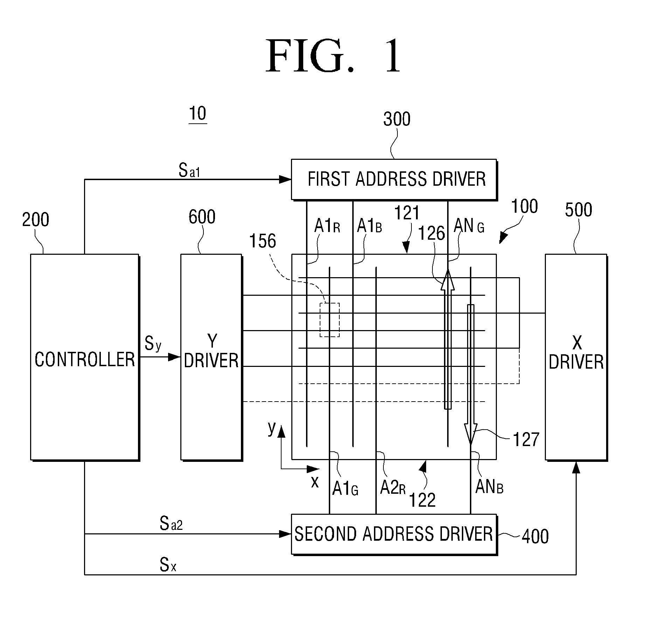

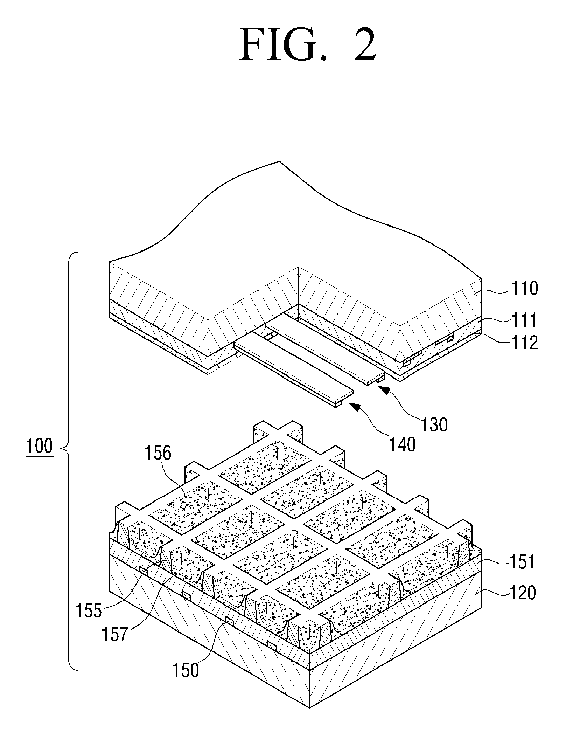

FIG. 1 is a schematic view illustrating a plasma display apparatus 10 according to an exemplary embodiment of the present invention, and FIG. 2 is an exploded perspective view illustrating a plasma display panel 100 of FIG. 1.

As shown in FIG. 1, a plasma display apparatus 10 according to an exemplary embodiment of the present invention includes a plasma display panel 100, a controller 200, a first address driver 300, a second address driver 400, an X driver 500, and a Y driver 600.

The plasma display panel 100 includes a first substrate 110, a second substrate 120, an X electrode 130, a Y electrode 140, and an address electrode 150, as shown in FIG. 2.

The first substrate 110 and the second substrate 120 face each other such that there is a predetermined gap between the first substrate 110 and the second substrate 120. Gas discharge is performed in the space between the first substrate 110 and the second substrate 120. Visible rays generated by the gas discharge are emitted to the outside through the first substrate 110. Therefore, the first substrate 110 is formed of a transparent material or a semitransparent material.

The X electrode 130 is arranged on the first substrate 110 along a first direction (x direction of FIG. 1). The X electrode 130 may be called a common electrode.

The Y electrode 140 is arranged on the first substrate 110 in parallel to the X electrode 130. The Y electrode may be called a scan electrode. As shown in FIGS. 1 and 2, the X electrode 130 and the Y electrode 140 are alternately arranged on the first substrate 110.

A first dielectric layer 111 is formed on the same surface of the first substrate 110 on which the X electrode 130 and the Y electrode 140 are arranged. The first dielectric layer 111 prevents the X electrode 130 and the Y electrode directly conducting when sustained discharge occurs, and prevents charged particles from directly colliding with the X electrode 130 and the Y electrode 140. The first dielectric layer 111 comprises lead oxide (PbO), diboron trioxide (B₂O₃), and silicon dioxide (SiO₂).

A protective layer 112 is formed on the first dielectric layer 111. The protective layer 112 prevents the X electrode 130 and the Y electrode 140 from being damaged by sputtering of plasma particles. The protective layer 112 also discharges secondary electrons to lower the discharge voltage. The protective layer 112 may comprise magnesium oxide (MgO).

The address electrode 150 is arranged on the second substrate 120 along a second direction (y direction of FIG. 1) which intersects with the first direction (x direction of FIG 1). The address electrode 150 performs address discharge along with the Y electrode 140. FIG. 2 illustrates the address electrode with a reference number 150, but FIG. 1 illustrates the address electrodes with the reference labels of A1_{R}, A1_{G}, A1_{B}, A2_{R}, A2_{G}, A2_{B},..., AN_{R}, AN_{G}, AN_{B} from the left side to the right side to explain arrangement of the address electrodes. The arrangement of the address electrodes will be explained below in further detail.

As shown in FIG. 2, a second dielectric layer 151 is formed on the same surface of the second substrate 120 on which the address electrodes 150 are arranged. The second dielectric layer 151 electrically insulates the address electrodes 150 from one another, and protects the address electrodes 150.

A partition 155 is formed on the second dielectric layer 151 and forms a plurality of discharge cells 156. The gas discharge is performed in the discharge cells 156 by filling the discharge cells 156 with discharge gases, such as argon, neon, and xenon. The partition 155 prevents electrical and optical cross-talk between the discharge cells 156.

A fluorescent substance is coated over the upper surface of the second dielectric layer 151 and the lateral surfaces of the partition 155, thereby forming a fluorescent layer 157. The fluorescent layer 157 is excited by ultraviolet rays generated during the gas discharge to produce visible rays, which are emitted to the outside through the first substrate 110. The fluorescent substance of Y(V,P)O₄:Eu may be used to express red color, the fluorescent substance of Zn₂SiO₄:Mn may be used to express green color, and the fluorescent substance of BAM:Eu may be used to express blue color.

The controller 200 controls the plasma display panel 100 to display an image on the plasma display panel 100. That is, the controller 100 generates a control signal by processing video data input from an external source and transmitting the control signal to the first and the second address drivers 300, 400, the X driver 500, and the Y driver 600. The control signal includes first and second address signals Sₐ₁, Sₐ₂ for the first and the second address drivers 300, 400, an X driving signal Sₓ for the X driver 500, and a Y driving signal S_{y} for the Y driver 600.

The first address driver 300 drives the address electrodes A1_{R}, A1_{B},..., AN_{G}, which are connected thereto through one end 121 of the second direction (y direction of FIG. 1) of the second substrate 120, according to the first address signal Sₐ₁ transmitted from the controller 200.

The second address driver 400 drives the address electrodes A1_{G}, A2_{R}, ..., AN_{B,} which are connected thereto through the other end 122 of the second direction (y direction of FIG. 1) of the second substrate 120, according to the second address signal Sₐ₂ transmitted from the controller 200.

The X driver 500 drives the X electrode 130 according to the X driving signal Sₓ transmitted from the controller 200, and the Y driver 600 drives the Y electrode 140 according to the Y driving signal S_{y} transmitted from the controller 200.

Hereinafter, the arrangement of the address electrodes A1_{R}, A1_{G}, A1_{B}, A2_{R}, A2_{G}, A2_{B},..., AN_{R}, AN_{G}, AN_{B} according to an exemplary embodiments of the present invention will be explained. The subscript "R" means that the address electrode corresponds to a discharge cell which discharges red visible rays, the subscript "G" means that the address electrode corresponds to a discharge cell which discharges green visible rays, and the subscript "B" means that the address electrode corresponding to a discharge cell which discharges blue visible rays. As shown in FIG. 1, at least one of the address electrodes A1_{R}, A1_{B}, ..., AN_{G} is connected to the first address driver 300 through one end 121 of the second direction (y direction of FIG. 1) of the second substrate 120, and its neighboring address electrode A1_{G}, A2_{R},..., AN_{B} is connected to the second address driver 400 through the other end 122 of the second direction (y direction of FIG. 1) of the second substrate 120. That is, the address electrodes A1_{R}, A1_{G}, A1_{B}, A2_{R}, A2_{G}, A2_{B},..., AN_{R}, AN_{G}, AN_{B} are alternately connected to the first address driver 300 through end 121 and the second address driver 400 through the other end 122 of the second direction (y direction of FIG. 1) of the second substrate 120. It should be noted that all address electrodes are not illustrated for the convenience of explanation. Such arrangement of address electrodes A1_{R}, A1_{G}, A1_{B}, A2_{R}, A2_{G}, A2_{B},..., AN_{R}, AN_{G}, AN_{B} results in the reduction of electromagnetic wave noise, which will be described in further detail below.

The operation of the plasma display apparatus 100 is well known to those skilled in the related art and thus will be explained briefly. If a predetermined address voltage is applied between the address electrode 150 and the X electrode 130, address discharge occurs, and consequently, a discharge cell is selected in which sustained discharge occurs. Then, if a sustained discharge voltage is applied between the X electrode 130 and the Y electrode 140 in the selected discharge cell, wall charge accumulates on the X electrode 130 and the Y electrode 140 moves, causing sustained discharge. An energy level of discharged gas excited by the sustained discharge is lowered such that ultraviolet rays are discharged. The ultraviolet rays excite the fluorescent substance of the fluorescent layer 157 in the discharge cell, and the energy level of the excited fluorescent substance is lowered such that visible rays are emitted. As a result, unwanted electromagnetic wave noise occurs during the operation of the plasma display apparatus, causing electromagnetic interference.

The operation of reducing the electromagnetic interference of the plasma display apparatus 10 according to an exemplary embodiment of the present invention will be explained with reference to two neighboring address electrodes AN_{G}, AN_{B} of FIG. 1.

First, the operation of reducing the noise which occurs during the sustained discharge is explained. The inventor of the present invention comes to know that the noise, which occurs in the X electrode 130 and the Y electrode 140 during the sustained discharge (called a sustained noise) propagates towards the address electrodes A1_{R}, A1_{G}, A1_{B}, A2_{R}, A2_{G}, A2_{B},..., AN_{R}, AN_{G}, AN_{B} which are maintained in a ground state during the sustained discharge, such that a vertical (y direction) radiation noise becomes the dominant noise source. Such noise is treated as common-mode noise. As described above, the first address electrode AN_{G} is connected to the first address driver 300 through one end 121 of the y direction of the second substrate 120, and the second address electrode AN_{B}, neighboring the first address electrode AN_{G}, is connected to the second address driver 400 through the other end 122 of the y direction of the second substrate 120. Accordingly, the sustained noise induced toward the first address electrode AN_{G} has a direction indicated by an arrow 126, and the sustained noise induced toward the second address electrode AN_{B} has a direction indicated by an arrow 127. That is, since the sustained noises propagated toward the two neighboring address electrodes AN_{G}, AN_{B}, which have opposite directions, are offset by each other thus reducing the radiation noise.

Second, the operation of reducing the noise which occurs when the address electrodes are driven will be described. As shown in FIG. 1, the first address electrode AN_{G} is driven by the first address driver 300, and the second address electrode AN_{B} is driven by the second address driver 400. In this case, the electric current flows through the two neighboring address electrodes AN_{G}, AN_{B} in opposite directions reducing the noise.

Although only the two address electrodes AN_{G}, AN_{B} are explained for the sake of simplicity, the same mechanism is applied to other address electrodes shown in FIG. 1 so that the noise can be reduced. As described above, the noise, which is incurred during the sustained discharge, and the noise, which is incurred when the address electrode is driven, are greatly reduced preventing electromagnetic interference.

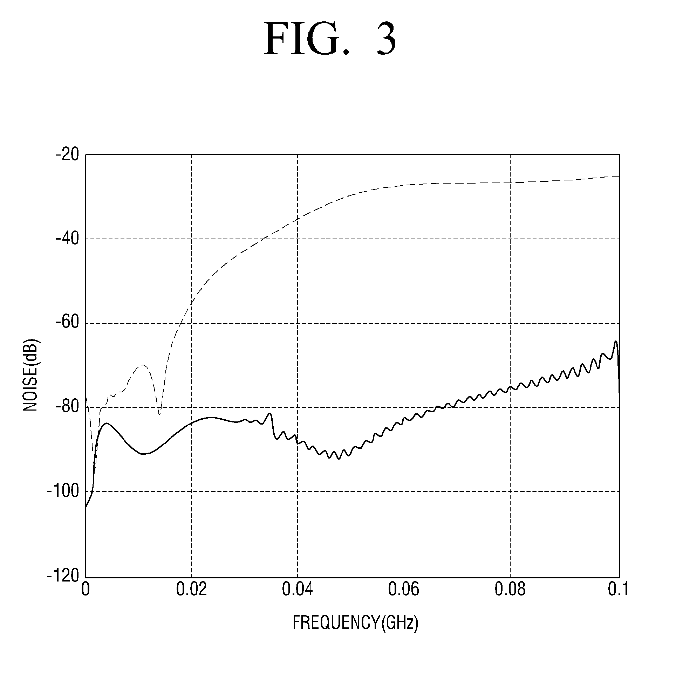

FIG. 3 is a graph comparing the result of simulating the vertical (y direction) radiation noise of the plasma display apparatus 10 of FIG. 1 with that of a related-art plasma display apparatus. The solid line of FIG. 3 indicates the level of noise in the plasma display apparatus 10 according to an exemplary embodiment of the present invention, and the dotted line of FIG. 3 indicates the level of noise in a related art plasma display apparatus. Referring to FIG. 3, the result of simulation shows that the radiation noise is greatly reduced in the exemplary embodiment of the present invention. More specifically, an experiment conducted by the inventor of the present invention shows that the noise is reduced by about 10dB at frequencies 30Mhz to 100Mhz. Therefore, according to the exemplary embodiment of the present invention described above, the electromagnetic interference is reduced without requiring an electromagnetic wave shielding filter, which may deteriorates the brightness of an image and increase the manufacturing cost of a plasma display apparatus.

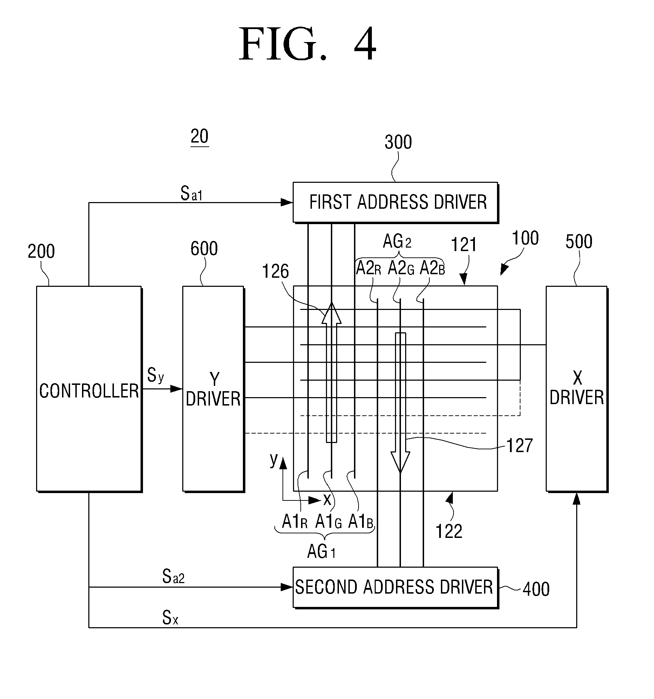

FIG. 4 is a schematic view illustrating a plasma display apparatus 20 according to another exemplary embodiment of the present invention. The components performing the same functions as those of the aforementioned embodiment are given the same reference numerals, and a detailed description thereof is omitted here.

This embodiment differs from the aforementioned embodiment in arrangement of address electrodes. That is, a predetermined number of continuous address electrodes form an address electrode group, which are alternately connected to the first and the second address drivers 300, 400 through one end 121 and the other end 122 of the y direction of the second substrate 120. Referring to FIG. 4, three continuous address electrodes A1_{R}, A1_{G}, A1_{B} form a first address electrode group AG₁, and another three continuous address electrodes A2_{R}, A2_{G}, A2_{B}, neighboring the address electrodes A1_{R}, A1_{G}, A1_{B}, form a second address electrode group AG₂. The first address electrode group AG₁ is connected to the first address driver 300 through one end 121 of the second direction (y direction of FIG. 4) of the second substrate 120, and the second address electrode group AG₂ is connected to the second address driver 400 through the other end 122 of the second direction (y direction of FIG. 4) of the second substrate 120.

In the same manner as that of the aforementioned embodiment, sustained noise propagates in the neighboring first and second address electrode groups AG₁, AG₂ during the sustained discharge in opposite directions, and electric current flows in the first and the second address electrode groups AG₁, AG₂ when the address electrodes are driven in opposite directions, so that noise can be greatly reduced.

Although in the embodiment shown in FIG. 4 three address electrodes form a address electrode group, the number of address electrodes to form an address electrode group can vary. For example, two address electrodes may form a single address electrode group.

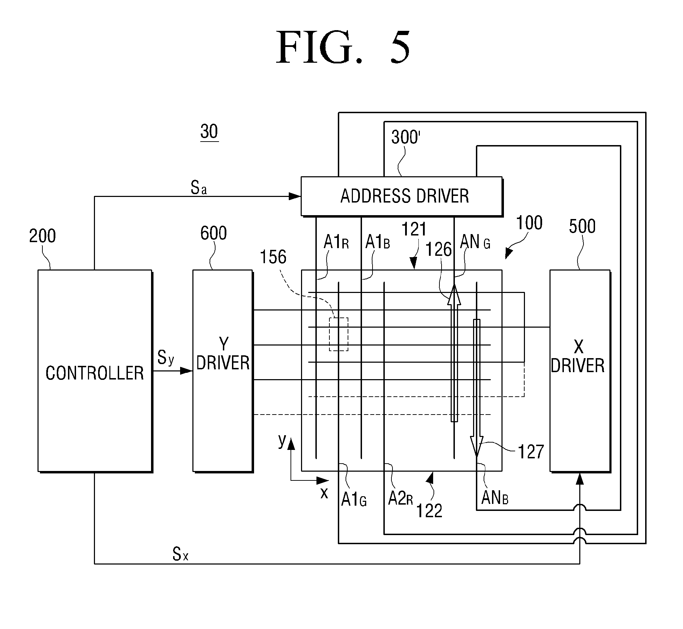

FIG. 5 is a schematic view illustrating a plasma display apparatus 30 according to still another exemplary embodiment of the present invention. The components performing the same functions as those of the aforementioned embodiments are given the same reference numerals, and a detailed description thereof is omitted here.

This embodiment differs from the aforementioned embodiments in that there is only a single address driver 300', not two address drivers. However, in the same manner as in the embodiment of FIG. 1, at least one address electrode A1_{R}, A1_{B}, ..., AN_{G} is connected to the address driver 300' through one end 121 of the second direction (y direction of FIG. 1) of the second substrate 120 and its neighboring address electrode A1_{G}, A2_{R},..., AN_{B} is connected to the address driver 300' through the other end 122 of the second direction (y direction of FIG. 1) of the second substrate 120. In the same manner as in the aforementioned embodiments, sustained noise propagates towards the two neighboring address electrodes during the sustained discharge in opposite directions, and electric current flows in the two address electrodes when the address electrode are driven in opposite directions, so that noise can be greatly reduced.

Since the embodiment of FIG. 5 has only a single address driver 300', the manufacturing cost of the plasma display apparatus 30 is further reduced.

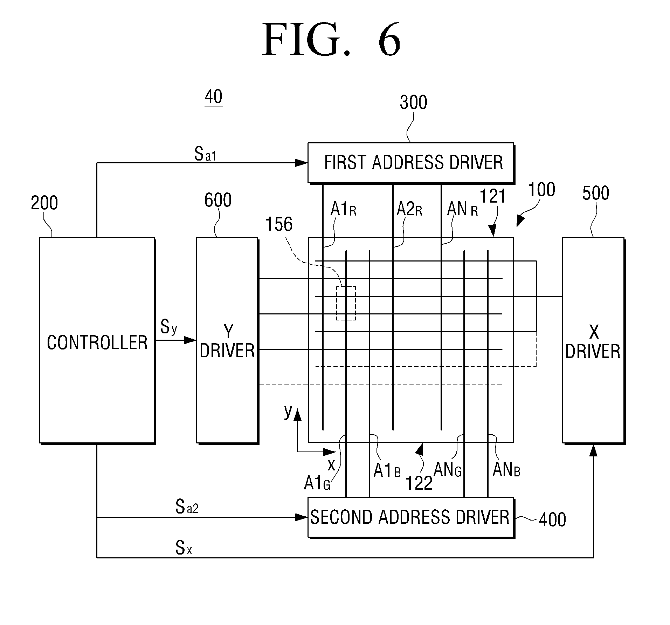

FIG. 6 is a schematic view illustrating a plasma display apparatus 40 according to still another exemplary embodiment of the present invention. The components performing the same functions as those of the aforementioned embodiments are given the same reference numerals, and a detailed description thereof is omitted here.

This embodiment differs from the aforementioned embodiments in the arrangement of the address electrodes. That is, an address electrode A1_{R}, A2_{R}, ..., AN_{R}, corresponding to a discharge cell discharging red visible rays, is connected to the first address driver 300 through one end 121 of y direction of the second substrate 120 and the other address electrode A1_{G}, A1_{B}, A2_{G}, A2_{B},..AN_{G}, AN_{B}, corresponding to discharge cells discharging green and blue visible rays, is connected to the second address driver 400 through the other end 122 of the y direction of the second substrate 120. For the same reason as that of the aforementioned embodiments, the noise is reduced in the embodiment of FIG. 6. However, the amount of reduced noise may be greater in the embodiments of FIGS. 1 and 5 than in the embodiment of FIG. 6.

Although in the embodiment of FIG. 6 the address electrode A1_{R}, A2_{R}, ..., AN_{R}, corresponding to the discharge cell discharging red visible rays, is connected to the first address driver 300 through one end 121 of the y direction of the second substrate 120, this can be modified. For example, an address electrode A1_{G}, A2_{G},..., AN_{G}, corresponding to a discharge cell discharging green visible rays, may be connected to the first address driver 300 through one end 121 of the y direction of the second substrate 120, or an address electrode A1_{B}, A2_{B},..., AN_{B}, corresponding to a discharge cell discharging blue visible rays, may be connected to the first address driver 300 through one end 121 of the y direction of the second substrate 120.

The foregoing exemplary embodiments and advantages are merely exemplary and are not to be construed as limiting the present invention. The present teaching can be readily applied to other types of apparatuses. Also, the description of the exemplary embodiments of the present invention is intended to be illustrative, and not to limit the scope of the claims, and many alternatives, modifications, and variations will be apparent to those skilled in the art.

## Claims

1. A plasma display apparatus comprising:
a first substrate and a second substrate which face each other with a predetermined gap between the first and the second substrate;
a plurality of X electrodes and a plurality of Y electrodes which are alternately arranged on the first substrate along a first direction;
a plurality of address electrodes which are arranged on the second substrate along a second direction which intersects with the first direction; and
an address driver which drives the plurality of address electrodes,
wherein at least one of the plurality of address electrodes is connected to the address driver through a first end in the second direction of the second substrate, and an address electrode neighboring the at least one of the plurality of address electrodes is connected to the address driver through a second end in the second direction of the second substrate.

2. The plasma display apparatus as claimed in claim 1, wherein the plurality of address electrodes are alternately connected to the address driver through the first end and the second end of the second substrate.

3. The plasma display apparatus as claimed in claim 1, wherein a predetermined number of the plurality of address electrodes form an address electrode group, and
a plurality of address electrode groups are alternately connected to the address driver through the first end and the second end of the second substrate.

4. The plasma display apparatus as claimed in any preceding claim, wherein the address driver comprises:
a first address driver which drives at least one of the plurality of address electrodes connected thereto through the first end of the second substrate; and
a second address driver which drives at least one of the plurality of address electrodes connected thereto through the second end of the second substrate.

5. The plasma display apparatus as claimed in any preceding claim, further comprising:
an X driver which drives the plurality of X electrodes; and
a Y driver which drives the plurality of Y electrodes.

6. The plasma display apparatus as claimed in claim 5, further comprising a controller which generates a control signal by processing input video data, and transmits the control signal to the address driver, the X driver, and the Y driver.

7. The plasma display apparatus as claimed in any preceding claim, further comprising:
a first dielectric layer formed on a surface the first substrate;
a protective layer formed on the first dielectric layer;
a second dielectric layer formed on a surface of the second substrate;
a plurality of discharge cells, which are separated by a partition, formed on the second dielectric layer; and
a fluorescent layer formed on the dielectric layer and a lateral surface of the parition.

8. The plasma display apparatus as claimed in any preceding claim, wherein the plurality of address electrodes comprise at least one electrode corresponding to a first discharge cell discharging red visible rays, at least one electrode corresponding to a second discharge cell discharging blue visible rays, and at least one electrode corresponding a third discharge cell discharging green visible rays.

9. The plasma display apparatus as claimed in claim 8, wherein
at least one of the plurality of address electrodes, corresponding to at least one of the first, second, and third discharge cells, is connected to the first end of the second substrate and at least one of the plurality of address electrodes,
corresponding to the discharge cells not connected to the first end of the second substrate, is connected to the second end of the second substrate.
